# EUROPEAN PATENT APPLICATION

(11) **EP 2 128 895 A2**
(43) Date of publication of application: **02.12.2009**
(21) Application number: 09161252.3
(22) Date of filing: 27.05.2009
(51) Int. Cl.: H01L 21/304, H01L 29/06, C30B 15/00

(54) **Semiconductor wafer**

(30) Priority: 28.05.2008 JP 2008139264
(71) Applicant: SUMCO Corporation, Tokyo 105-8634 (JP); Sumco Techxiv Corporation, Omura-shi, Nagasaki 856-8555 (JP)
(72) Inventor: Koyata, Sakae, Tokyo 105-8634 (JP); Hashii, Tomohiro, Tokyo 105-8634 (JP); Yamada, Yasunori, Tokyo 105-8634 (JP); Yukiwaki, Satoshi, Tokyo 105-8634 (JP); Sakamoto, Shinji, Nagasaki 856-8555 (JP); Ohmachi, Tomoko, Nagasaki 856-8555 (JP)
(74) Representative: Cabinet Plasseraud

(57) **Abstract**

A semiconductor wafer has a diameter of 450 mm and a thickness of at least 725 µm and no greater than 900 µm.

## Description

This application is based on and claims the benefit of priority from Japanese Patent Application No. 2008-139264, filed on 28 May 2008, the content of which is incorporated herein by reference.

### BACKGROUND OF THE INVENTION

### Field of the Invention

The present invention relates to a semiconductor wafer.

### Related Art

Recently, size of a semiconductor wafer (hereinafter also referred to simply as "wafer") used for manufacturing a semiconductor device is required to be larger, as size of chips increases in accordance with high integration and functionality of semiconductor devices.

However, a large diameter wafer may cause various problems during manufacture. For example, Japanese Unexamined Patent Application Publication No. 2004-95942 (Patent Document 1) proposes technology for determining width of a groove on a wafer cassette for batch transportation by calculating an amount of deflection on the basis of diameter and thickness of a wafer to be loaded on the wafer cassette.

### SUMMARY OF THE INVENTION

The disclosure in Patent Document 1 is regarding a wafer that has become thin after grinding of a reverse side thereof; however, also in a case of a large diameter semiconductor wafer, increased amount of deflection due to the wafer's own weight leads to a problem in loading and unloading of a wafer in a storage container and a problem of transportability of a wafer in a processing device, a manufacturing device, and the like.

Given this, the present invention aims at providing a semiconductor wafer that enables loading and unloading thereof with regard to a storage container, and transportation thereof, in a processing device, a manufacturing device, and the like.

In a first aspect of the present invention, a semiconductor wafer has a diameter of 450 mm and a thickness of at least 725 µm and no greater than 900 µm.

According to the present invention, a semiconductor wafer that enables loading and unloading thereof with regard to a storage container, and transportation thereof, in a processing device, a manufacturing device, and the like can be provided.

### BRIEF DESCRIPTION OF THE DRAWINGS

FIGS. 1A to 1C are diagrams illustrating an embodiment of a semiconductor wafer 1 according to the present invention;
FIG. 1A is a perspective view;
FIG. 1B is a diagram illustrating the semiconductor wafer 1 seen from a thickness direction;
FIG. 1C is a diagram illustrating the semiconductor wafer 1 seen from a diameter direction;
FIG. 2 is a flow chart showing manufacturing steps of the semiconductor wafer 1 according to the present embodiment;
FIG. 3 is a plan view showing a measuring method of an amount of deflection of the wafer 1;
FIG. 4 is a diagram showing a relationship between thickness of the wafer and the amount of deflection at a position B, measured by the measuring method shown in FIG. 3;
FIG. 5 is a chart showing a relationship between each measured position on the wafer and the amount of deflection, measured by the measuring method shown in FIG. 3;
FIG. 6 is a plan view showing another measuring method of an amount of deflection of the wafer 1;
FIGS. 7A and 7B are charts showing a relationship between each measured position on the wafer and the amount of deflection, measured by the measuring method shown in FIG. 6;

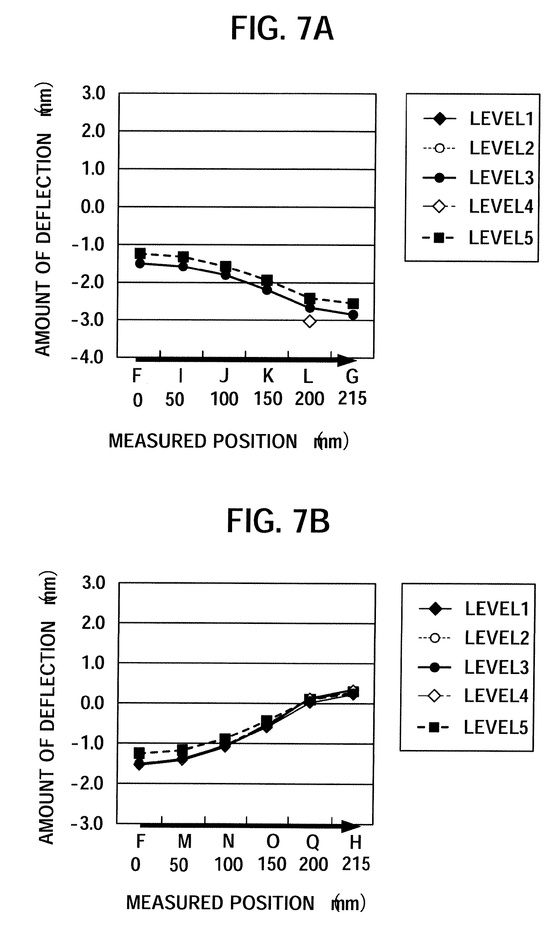

FIG. 7A is a chart showing a relationship between each measured position on the wafer, from a center F to a position G, and the amount of deflection;
FIG. 7B is a chart showing a relationship between each measured position on the wafer, from a center F to a position H, and the amount of deflection;

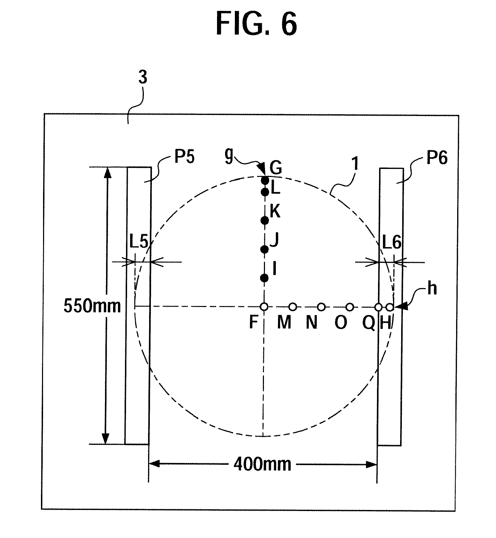

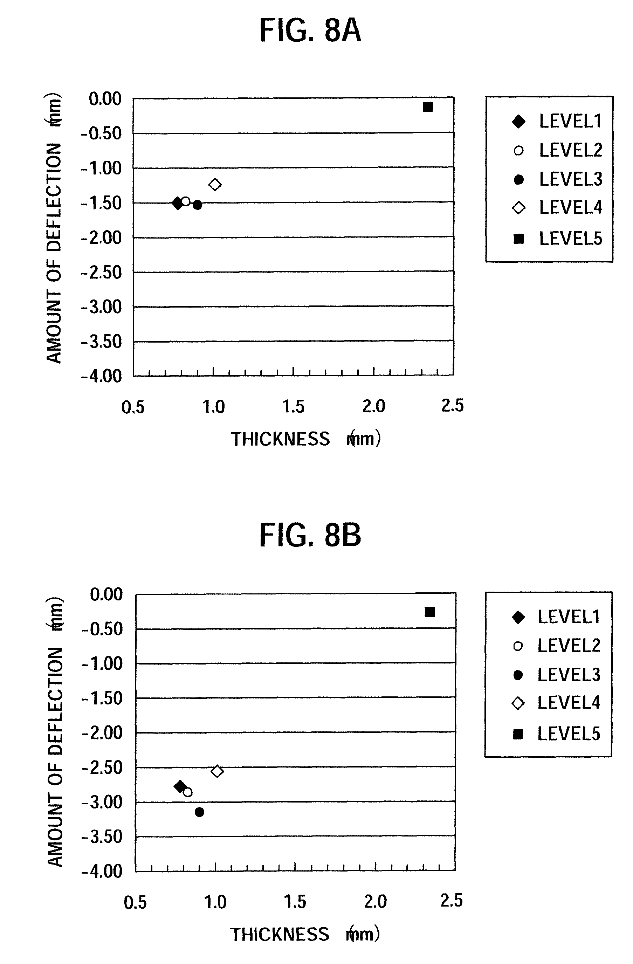

FIGS. 8A and 8B are charts showing a relationship between thickness of each wafer and the amount of deflection, measured by the measuring method shown in FIG. 6;
FIG. 8A is a chart showing a relationship between thickness and the amount of deflection at the center F;
FIG. 8B is a chart showing a relationship between thickness and the amount of deflection at the position H; and

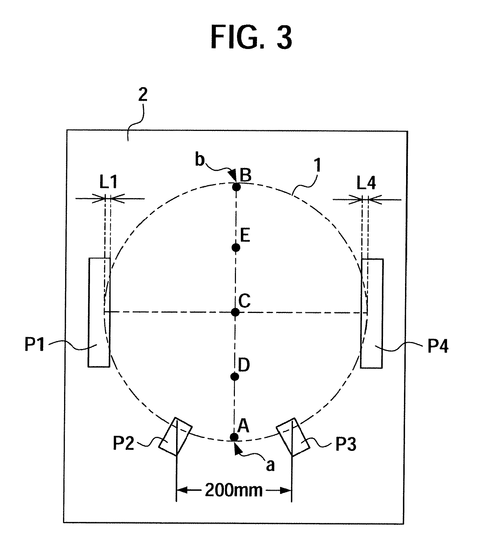

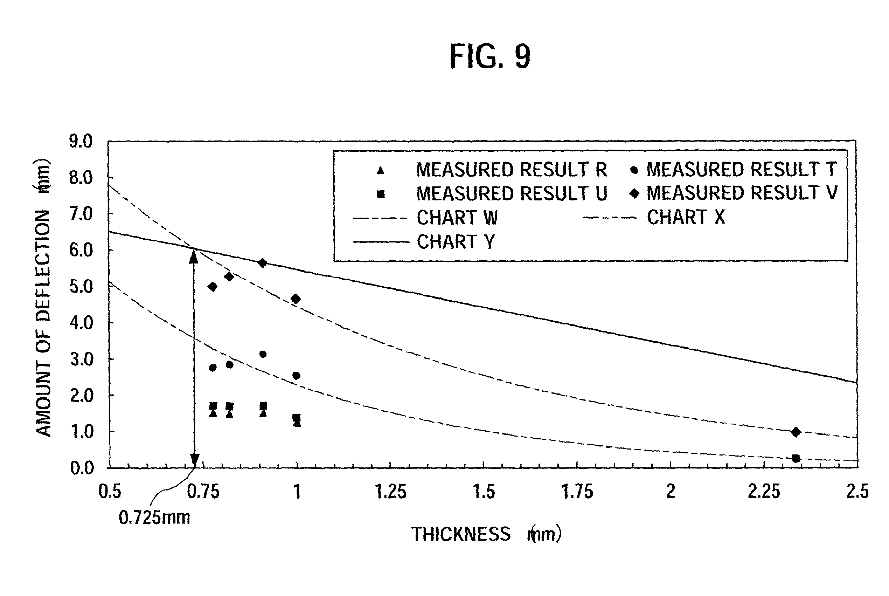

FIG. 9 is a chart showing a relationship between thickness of a wafer and the amount of deflection, based on the result of FIGS. 3 to 8B.

### DETAILED DESCRIPTION OF THE INVENTION

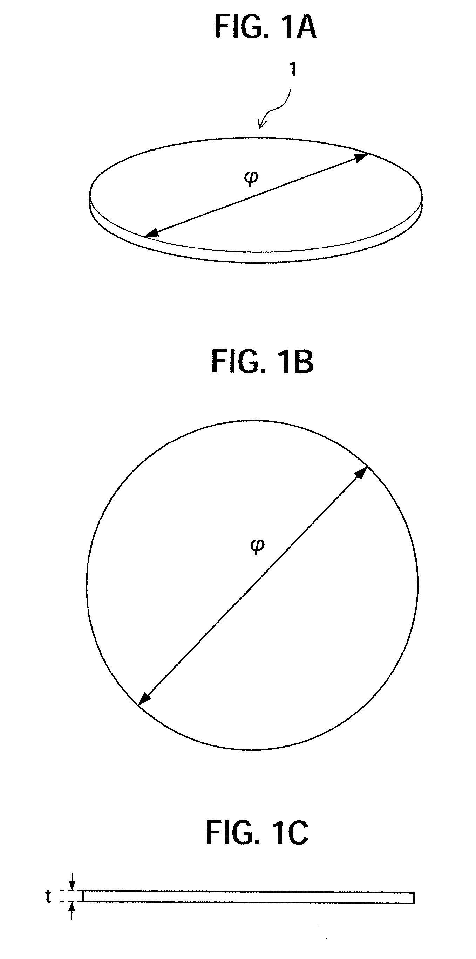

An embodiment of the semiconductor wafer according to the present invention is hereinafter described with reference to the drawings. FIGS. 1A to 1C are diagrams illustrating an embodiment of a semiconductor wafer 1 according to the present invention: FIG. 1A is a perspective view, FIG. 1B is a diagram illustrating the semiconductor wafer 1 seen from a thickness direction, and FIG. 1C is a diagram illustrating the semiconductor wafer 1 seen from a diameter direction.

A semiconductor wafer 1 (hereinafter also referred to simply as "wafer") according to the present embodiment has a diameter of 450 mm and a thickness of at least 725 µm and no greater than 900 µm.

In addition, the wafer 1 according to the present embodiment is, for example, a silicon wafer or a gallium arsenide wafer.

As shown in FIGS. 1A and 1B, the wafer 1 according to the present embodiment has a diameter ø of 450 mm. Here, the diameter ø of the wafer 1 is a desired value in manufacturing, and includes an allowable margin of error and the like in manufacturing. For example, the diameter ø of the wafer 1 includes an allowable margin of error of ± 0.2 mm.

In the wafer 1 according to the present embodiment, a thickness t shown in FIG. 1C is at least 725 µm. The significance thereof is that, in a case where the wafer 1 has the diameter ø of 450 mm and the thickness t of at least 725 µm, an amount of deflection of the wafer 1 is equivalent to that of conventional semiconductor wafers and therefore a storage container, a manufacturing device and the like of the wafer 1 can be designed and manufactured by applying the amount of deflection of the conventional semiconductor wafers. The thickness t is preferably at least 800 µm.

An evaluation example showing that the amount of deflection of the wafer 1 is equivalent to that of the conventional semiconductor wafers is described later in detail in the EXAMPLE section.

In addition, the wafer 1 according to the present embodiment has the thickness t no greater than 900 µm. The significance thereof is that an increase in cost of the wafer 1 can be avoided. In a case where the thickness t exceeds 900 µm, the wafer 1 increases in weight and a larger amount of material is required, and therefore the wafer 1 increases in cost. The thickness t is preferably no greater than 850 µm.

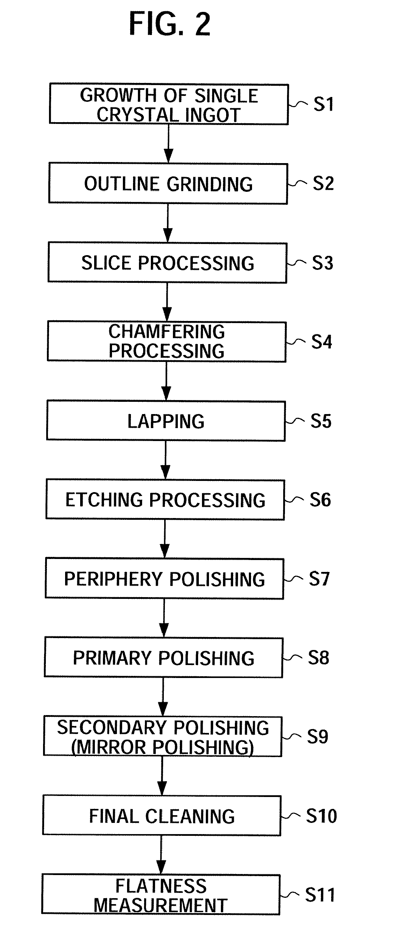

A manufacturing method for the wafer 1 according to the present embodiment is hereinafter described. FIG. 2 is a flow chart showing a manufacturing method for the semiconductor wafer 1 according to the present embodiment. As shown in FIG. 2, the manufacturing method for the semiconductor wafer 1 according to the present embodiment includes the following steps S1 to S11.

### (S1) Single Crystal Ingot Growth Step

First, a single crystal semiconductor ingot is grown by Czochralski method (CZ method), floating zone melting method (FZ method), or the like.

### (S2) Outline Grinding Step

The semiconductor ingot grown through the single crystal ingot growth step S1 has a front end portion and a rear end portion thereof cut off. Since the semiconductor ingot after being cut has a distorted outline shape, in the outline grinding step, outline of the semiconductor ingot is ground by a cylindrical grinder or the like to trim the outline shape and give a block body having a uniform diameter.

### (S3) Slice Processing Step

An orientation flat or orientation notch is formed on the block body after the outline grinding step S2, to indicate a particular crystal orientation. After the processing, the block body is sliced with a wire saw or the like to give a wafer.

### (S4) Chamfering Step

A wafer obtained as a result of the slice processing step S3 is chamfered on a periphery thereof to prevent cracking and chipping on the periphery thereof. In other words, the peripheral portion of the wafer is chamfered into a predetermined shape by means of a chamfering grindstone. By the processing, the peripheral portion of the wafer is formed into a shape with a predetermined roundness.

### (S5) Lapping Step

After the chamfering step S4, a rough layer on each surface of the wafer of a thin disk shape, generated by processing such as slicing, is made flat by lapping. In the lapping step, the wafer is disposed between lapping plates that are parallel to each other, and a lapping liquid, which is a mixture of alumina abrasive grains, a dispersing agent, and water, is poured in between the lapping plates and the wafer. Thereafter, the lapping plates and the wafer are rotated and ground together under pressure, thereby lapping both surfaces of the wafer. This can improve the flatness of each surface and the parallelism of both surfaces of the wafer.

### (S6) Etching Step

After the lapping step S5, the wafer is dipped in an etching solution and etched. In the etching step, the etching solution is supplied on a surface of the wafer while the wafer is spun by means of an etching device, for example. Then the etching solution being supplied spreads on a whole surface of the wafer by a centrifugal force of spinning, thereby etching the whole surface of the wafer and controlling surface roughness Ra of the surface of the wafer to be a predetermined surface roughness. In this etching step, a work-affected layer introduced by the mechanical processes such as the chamfering step S4 and lapping step S5 is completely removed by etching.

### (S7) Periphery Polishing Step

After the etching step S6, a peripheral portion of the wafer is subjected to periphery polishing. The chamfered surface of the wafer is thus mirror-polished. In the periphery polishing step, the chamfered surface of the wafer is pressed against a peripheral surface of a polishing cloth circulating about an axis, while supplying polishing liquid, thereby mirror-polishing the chamfered surface.

### (S8) Primary Polishing Step

After the periphery polishing step S7, the wafer is subjected to primary polishing as coarse polishing of surfaces thereof, using a simultaneous double side polishing device that polishes both surfaces simultaneously.

### (S9) Secondary Polishing (Mirror Polishing) Step

After the primary polishing step S8, the wafer is subjected to secondary polishing as mirror polishing, using a simultaneous double side polishing device that polishes both surfaces simultaneously. It should be noted that, although both surfaces of the wafer are simultaneously polished by simultaneous double side polishing in the primary polishing step S8 and the secondary polishing step S9, the wafer can also be polished by single side polishing that polishes one surface thereof at a time.

### (S10) Final Cleaning Step

After the secondary polishing (mirror polishing) step S9, the wafer is subjected to final cleaning. More specifically, after the secondary polishing step S9, the wafer is cleaned with RCA cleaning solution.

### (S11) Flatness Measurement

After the final cleaning step S10, flatness of the wafer is measured as a finish level of polishing.

The wafer 1 having the diameter ø of 450 mm and the thickness t of at least 725 µm and no greater than 900 µm can be obtained by the manufacturing steps as described in the abovementioned steps S1 to S11.

In the wafer 1 according to the present embodiment, since the thickness t thereof is at least 725 µm, an amount of deflection of the wafer 1 is equivalent to that of conventional semiconductor wafers in designing and manufacturing of a storage container, a processing device and the like. Therefore, a storage container, a processing device and the like can be designed and manufactured more easily. For example, loading and unloading of the wafer 1 in a storage container, and various handlings of the wafer 1 by a processing device and the like are possible. In addition, in the storage container, the processing device and the like, wafers can be prevented from contacting each other and a member that is supposed not to be contacted, thereby preventing scratching, breakage, cracking and the like of the wafers.

Furthermore, with the wafer 1 according to the present embodiment, since the thickness t of the wafer 1 is no greater than 900 µm, an increase in weight thereof and an increase in amount of wafer material used can be prevented, thereby avoiding an increase in cost of the wafer 1.

### EXAMPLES

Next, the present invention is described further in detail using examples. The examples are not intended to limit the scope of the present invention.

### Evaluation Example 1

First, Evaluation Example 1 for an amount of deflection of the wafer 1 is described hereinafter. FIG. 3 is a plan view showing a measuring method of an amount of deflection of the wafer 1.

As shown in FIG. 3, four holding members P1 to P4 are disposed at predetermined positions on a horizontal base 2. The wafer 1 having a diameter ø of 450 mm is placed such that an edge portion thereof (shown by two-dot chain line in FIG. 3) is supported by the four holding members P1 to P4. The holding members P1 and P4 are disposed at positions displaced from each other by 180°, across a center C of the wafer 1. The holding members P2 and P3 are disposed symmetrically across an edge portion (a), with an interspace of 200 mm. The edge portion (a) is an edge portion of the wafer 1. The edge portion (a) is at a position displaced by 90° from the holding member P1 and the holding member P4 respectively.

Such an arrangement of the holding members P1 to P4 is a model arrangement of positions where a reverse side of a wafer is held in a storage container, in a case where the wafer 1 is loaded in a wafer storage container (FOSB). As the wafer 1, five levels of different thicknesses (level 1: 0.779 mm, level 2: 0.826 mm, level 3: 0.900 mm, level 4: 1.012 mm, and level 5: 2.338 mm) were provided. The levels 1 to 3 are examples of the present invention. And the levels 4 and 5 are comparative examples of the present invention.

The wafer 1 of each of the levels 1 to 5 is placed on the holding members P1 to P4. Here, a contacting width L 1 is defined at a position where length of the edge portion of the wafer 1 contacting the holding member P1 is the greatest. The contacting width L1 is 7.5 mm in length, from the edge portion of the wafer 1 toward the center C of the wafer 1. Similarly, a contacting width L4 is defined at a position where length of the edge portion of the wafer 1 contacting the holding member P4 is the greatest. The contacting width L4 is 7.5 mm in length, from the edge portion of the wafer 1 toward the center C of the wafer 1.

Here, a position 10 mm away from a predetermined edge portion (a) of the wafer 1 toward a center of the wafer is taken as a position A. In addition, a position 10 mm away from a predetermined edge portion (b) of the wafer 1 toward a center of the wafer is taken as a position B. The edge portion (b) is a position displaced by 180° from the edge portion (a), across a center C of the wafer 1. A midpoint between the center C of the wafer 1 and the edge portion (a) (a position ø/4 away from the center C of the wafer) is taken as a position D. In addition, a midpoint between the center C of the wafer 1 and the edge portion (b) (a position ø/4 away from the center C of the wafer) is taken as a position E.

Subsequently, an amount of deflection of the wafer was measured optically, from the position A to the position B, at the position A, the position D, the center C of the wafer, the position E, and the position B. As a reference value of the amount of deflection, an amount of deflection of the edge portion of the wafer on the holding members P1 to P4 was used (amount of deflection: 0).

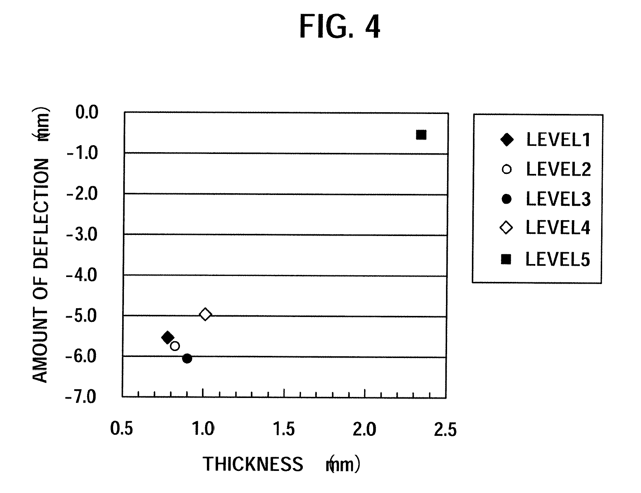

FIG. 4 is a diagram showing a relationship between thickness of the wafer and the amount of deflection at a position B, measured by the measuring method shown in FIG. 3. The amount of vertically downward deflection of the wafer 1 is hereinafter referred to as amount of negative (-) deflection. On the other hand, the amount of vertically upward deflection of the wafer 1 is hereinafter referred to as amount of positive (+) deflection.

As shown in FIG. 4, the amount of deflection did not simply become greater as thickness of the wafer became smaller, and a peak value of the amount of deflection was obtained with the level 3 (0.900 mm in thickness).

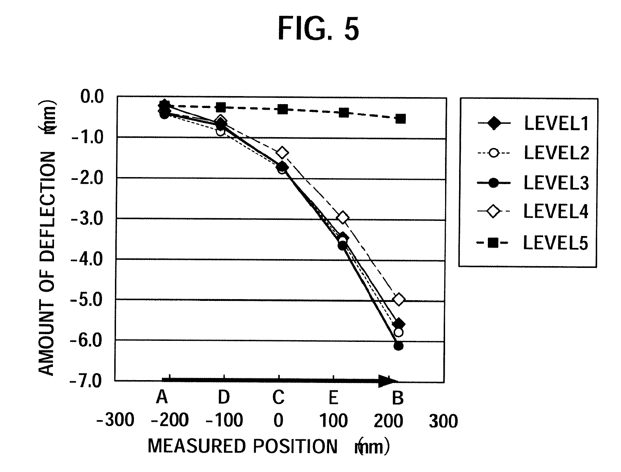

FIG. 5 is a chart showing a relationship between each measured position on the wafer and the amount of deflection, measured by the measuring method shown in FIG 3.

As shown in FIG. 5, the amount of deflection of the wafer tends to become greater approaching the position B, which is away from the holding members P2 and P3, and moving away from the position A that is close to the positions supported by the holding members P2 and P3. This tendency is particularly significant with the level 1 to the level 4.

### Evaluation Example 2

Next, Evaluation Example 2 for amount of deflection of the wafer 1 is described hereinafter. FIG. 6 is a plan view showing another measuring method of the amount of deflection of the wafer 1.

As shown in FIG. 6, two holding members P5 and P6 are disposed at predetermined positions on a horizontal base 3. The wafer 1 having a diameter ø of 450 mm is placed such that an edge portion thereof (shown by two-dot chain line in FIG. 6) is supported by the two holding member P5 and P6. The holding members P5 and P6 are disposed at positions displaced from each other by 180°, across a center C of the wafer 1. Such an arrangement of the holding members P5 and P6 is a model arrangement of positions where a reverse side of a wafer is held in a processing device or the like, in a case where the wafer 1 is supported by a processing device and the like.

Here, length in the longitudinal direction of the holding members P5 and P6 is 550 mm. A distance between the holding member P5 and the holding member P6 is 400 mm. The edge portion (g) is an edge of the wafer 1. The edge portion (g) is at a position displaced by 90° from the holding member P5 and the holding member P6 respectively. The edge portion (h) is a position displaced by 90° from the edge portion (g). The edge portion (h) overlaps the holding member P6. As the wafer 1, five levels with different thicknesses (level 1: 0.779 mm, level 2: 0.826 mm, level 3: 0.900 mm, level 4: 1.012 mm, and level 5: 2.338 mm) were provided as in Evaluation Example 1. The levels 1 to 3 are examples of the present invention. The levels 4 and 5 are comparative examples of the present invention.

The wafer 1 of each of the levels 1 to 5 is placed on the holding members P5 and P6. Here, a contacting width L5 is defined at a position where length of the edge portion of the wafer 1 contacting the holding member P5 is the greatest. The contacting width L5 is 25 mm in length, from the edge portion of the wafer 1 toward the center F of the wafer 1. Similarly, the contacting width L6 is defined at a position where length of the edge portion of the wafer 1 contacting the holding member P6 is the greatest. The contacting width L6 is 25 mm in length, from the edge portion of the wafer 1 toward the center F of the wafer 1.

Here, a position 10 mm away from a predetermined edge portion (g) of the wafer 1 toward a center of the wafer is taken as a position G. Here, a position 10 mm away from a predetermined edge portion (h) of the wafer 1 toward a center of the wafer is taken as a position H. Positions 50 mm, 100 mm, 150 mm, and 200 mm away from the center F toward the position G are taken as positions I, J, K and L, respectively. Positions 50 mm, 100 mm, 150 mm, and 200 mm away from the center F toward the position H are taken as positions M, N, O and Q, respectively.

Subsequently, amount of deflection of the wafer was measured optically at the center F, the position I, the position J, the position K, and the position L. In addition, amount of deflection of the wafer was measured optically at the center F, the position M, the position N, the position O, and the position Q. As a reference value of the amount of deflection, amount of deflection of the position Q supported by the holding member P6 was used (amount of deflection: 0).

FIGS. 7A and 7B are charts showing a relationship between each measured position on the wafer and the amount of deflection, measured by the measuring method shown in FIG. 6. FIG. 7A is a chart showing a relationship between each measured position on the wafer, from the center F to the position G, and the amount of deflection. FIG. 7B is a chart showing a relationship between each measured position on the wafer, from the center F to the position H, and the amount of deflection.

As shown in FIG. 7A, the amount of deflection of the wafer tends to become greater as a measured position approaches the edge portion (g) of the wafer 1 that is not supported by the holding members P5 and P6, away from the center F.

In addition, as shown in FIG. 7B, the amount of deflection of the wafer tends to become greater as a measured position approaches the center F that is not supported by the holding members P5 and P6, away from the position H that is supported by the holding member P6.

FIGS. 8A and 8B are charts showing a relationship between thickness of each wafer and the amount of deflection, measured by the measuring method shown in FIG. 6. FIG. 8A is a chart showing a relationship between thickness and the amount of deflection at the center F. FIG. 8B is a chart showing a relationship between thickness and the amount of deflection at the position G.

As shown in FIG. 8A, at the center F, the amount of deflection of the wafer tends to become greater as the thickness of the wafer becomes smaller. In addition, as shown in FIG. 8B, a similar tendency is observed at the position G, with a greater amount of deflection than at the center F. The amount of deflection did not simply become greater as thickness of the wafer became smaller, and a peak value of the amount of deflection was obtained with the level 3 (0.900 mm in thickness).

FIG. 9 is a chart showing a relationship between thickness of a wafer and the amount of deflection, based on the result of FIGS. 3 to 8B.

As shown in FIG. 9, a measured result R (triangle) shows a result of measurement at the center F according to the abovementioned measuring method shown in FIG. 6. A measured result T (circle) shows a result of measurement at the position G according to the abovementioned measuring method shown in FIG. 6. A measured result U (square) shows a result of measurement at the center C according to the abovementioned measuring method shown in FIG. 3. A measured result V (diamond) shows a result of measurement at the position B according to the abovementioned measuring method shown in FIG. 3.

In addition, a chart X (two-dot chain line) is a chart showing a relationship between the thickness of the wafer and the amount of deflection, which is calculated from the measured result at the position B according to the abovementioned measuring method shown in FIG. 3. A chart W (dashed-dotted line) is a chart showing a relationship between the thickness of the wafer and the amount of deflection, which is calculated from the measured result at the position G according to the abovementioned measuring method shown in FIG. 6. Furthermore, a chart Y (full line) is a chart showing a relationship between the thickness of the wafer and an acceptable value of the amount of deflection in a case where a storage container and a processing device and the like, to which an amount of deflection of the conventional wafer is applied, are used, in consideration of a margin required for loading and unloading the wafer from the storage container by the processing device and the like.

As shown in FIG. 9, an intersection point of the chart X and the chart Y corresponds to a thickness of the wafer of 725 µm. Therefore, in a case where the thickness of the wafer is at least 725 µm, loading and unloading of the wafer by a processing device and the like from a storage container is possible. In addition, an intersecting point of the measured result V and the chart Y corresponds to a thickness of the wafer of 900 µm. Therefore, in a case where the thickness of the wafer is no greater than 900 µm, loading and unloading of the wafer by a processing device and the like from a storage container is possible.

## Claims

1. A semiconductor wafer having a diameter of 450 mm and a thickness of at least 725 µm and no greater than 900 µm.
